(19) Europäisches Patentamt / European Patent Office / Office européen des brevets

(11) **EP 4 648 281 A1**

(12) **EUROPEAN PATENT APPLICATION**

(43) Date of publication:
**12.11.2025 Bulletin 2025/46**

(21) Application number: **25171361.6**

(22) Date of filing: **17.04.2025**

(51) International Patent Classification (IPC):
**H03F 1/26** (2006.01)     **H03F 3/187** (2006.01)
**H03F 3/217** (2006.01)

(52) Cooperative Patent Classification (CPC):
**H03F 3/217; H03F 1/26; H03F 3/187; H03F 3/2175;**
H03F 2200/03; H03F 2200/351

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **06.05.2024 US 202418655647**

(71) Applicant: **STMicroelectronics International N.V.
1228 Plan-les-Ouates, Geneva (CH)**

(72) Inventors:
• **STILGENBAUER, Francesco**
  **I-20017 Rho (Milano) (IT)**
• **RAIMONDI, Marco**
  **I-20038 Busto Garolfo (Milano) (IT)**
• **GALLO, Noemi**
  **I-20100 Cornaredo (Milano) (IT)**
• **TARANTO, Costantino**
  **I-87064 Corigliano-Rossano (Cosenza) (IT)**

(74) Representative: **Buzzi, Notaro & Antonielli d'Oulx
S.p.A.
Corso Vittorio Emanuele II, 6
10123 Torino (IT)**

(54) **NOISE SHAPER BASED SPREAD SPECTRUM FOR PULSE WIDTH MODULATION**

(57)     A class-D amplifier includes modulated carrier-generation circuitry generating a modulated carrier-wave having a variable period but a constant peak-to-peak voltage, a PWM signal generator generating a PWM-signal by comparing an input-voltage to the modulated carrier-wave, and an h-bridge generating an output signal from the PWM signal. The modulated carrier-generation circuitry generates a noise-shaping output from the modulating-wave and adds this to a carrier-wave fundamental-period to produce a counting-top signal. Based upon the counting-top signal, polarity and magnitude generation circuitry controls the magnitude and direction of current produced by a current source and provided to an integration capacitor of an integrator to generate the modulated carrier-wave. A counter iterates until a count equals the counting-top signal, then resets the count and activates noise-shaping circuitry to produce a new noise-shaping output, to cause change of the magnitude and direction of the current to yield the modulated carrier-wave.

FIG. 6

EP 4 648 281 A1

**Description**

TECHNICAL FIELD

This disclosure is directed to the field of class-D amplifiers.
One or more embodiments can be applied to the generation of a spread spectrum PWM signal within a class-D amplifier with reduced noise harmonics.

BACKGROUND

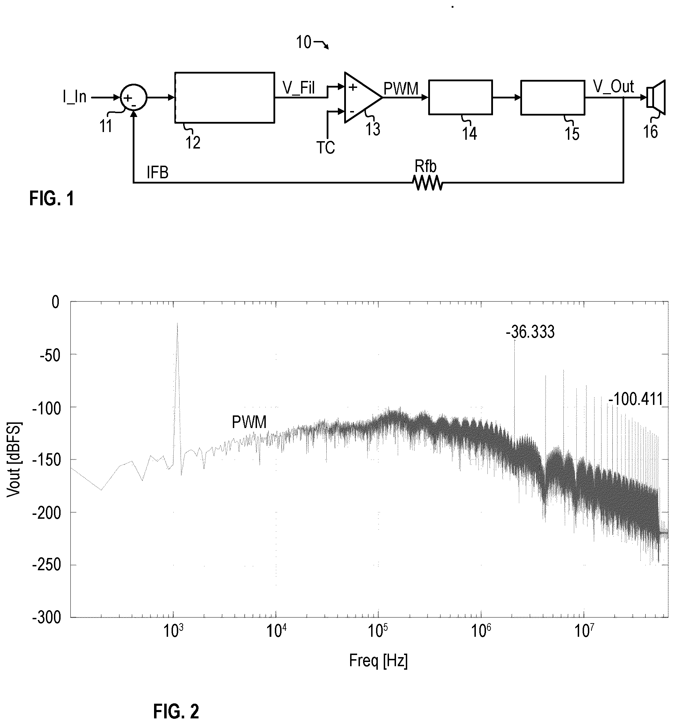

Class-D amplifiers are known for their high efficiency as they generate less heat than their analog counterparts (like Class A, B, or AB amplifiers) and can be made very compact. They are commonly used in portable and battery-powered applications like mobile phones and Bluetooth speakers.
A known class-D amplifier 10 shown in FIG. 1 includes:

- a voltage summing block 11 that processes a differential signal by subtracting a feedback current IFB from an input audio signal I_In,
- with the resulting signal being filtered by a filter and compensation circuit 12 to produce a filtered/compensated audio signal V_Fil.
- A comparator or PWM modulator 13 compares the filtered/compensated audio signal V_Fil at its non-inverting input to a triangular carrier signal, TC at its inverting input - to produce a pulse-width modulation signal PWM that mirrors the amplitude variations of the input audio signal I_In over time.

The PWM signal is then used to control the transistors in an H-bridge circuit 14, generating an amplified signal that is filtered by LC filter 15 to smooth out high-frequency components resulting from the pulse-width modulation, reconstructing an analog audio signal V_Out. This resulting analog signal V_Out may then be passed to a loudspeaker 16, which converts it back into audible sound waves.
While the class-D amplifier 10 has high efficiency, the use of a fixed-frequency triangular carrier TC for pulse width modulation introduces a challenge; it leads to distinct peaks in the spectrum of the pulse-width modulation signal PWM at the fundamental frequency of the triangular carrier signal and its harmonics before filtering, which can contribute to electromagnetic interference (EMI), potentially affecting nearby electronic devices.
Referring now to FIG. 2, a graph of the frequency spectrum of the output of the H-Bridge 14 shows the issue. There is a -36.333 dBFS spike observed at a frequency of about $2 \cdot 10^6$ Hz corresponding to the fundamental frequency of the triangular carrier signal, and its higher frequency harmonics are also visible, with an example -100.41 dBFS harmonic spike observed at about $10^7$ Hz. These voltage spikes are indicative of the spectral content that can lead to EMI, making it an undesirable characteristic. As such, further development in the area of class-D amplifiers is necessary.

SUMMARY

Disclosed herein is a class-D amplifier including modulated carrier generation circuitry configured to generate a modulated carrier wave having a variable period but a constant peak-to-peak voltage.
The modulated carrier generation circuitry includes: modulation circuitry configured to generate a modulating wave; noise shaping circuitry configured to perform noise shaping on the modulating wave to produce a noise shaping output; carrier generation circuitry configured to generate a programmable constant representing a fundamental period of a carrier wave; an adder configured to add the programmable constant to the noise shaping output to produce an updated counting top signal representative of a new top count value; control signal generation circuitry configured to generate at least one control signal in response to receipt of the updated counting top signal; a counter configured to iterate a count until the count reaches the new top count value, then reset the count and activate the noise shaping circuitry to produce a new noise shaping output; and integration circuitry configured to generate the modulated carrier wave based upon the at least one control signal.
The modulated carrier generation circuitry may be implemented digitally in an integrated circuit such that: the modulating wave is represented as a series of digital values; the noise shaping output is represented as a series of digital values; the new top count value is represented as a digital value; and the count is represented as a digital value.
The class-D amplifier includes PWM signal generator configured to generate a PWM signal by comparing an input voltage to the modulated carrier wave, and a bridge circuit configured to generate an output signal from the PWM signal.
The control signal generation circuitry may include: polarity generation circuitry configured to invert a polarity signal in response to receipt of the updated counting top signal to produce an updated polarity signal; and magnitude generation circuitry configured to generate an updated magnitude signal based upon the new top count value, in response to receipt of the updated counting top signal. The at least one control signal generated by the control signal generation circuitry may be the updated polarity signal and the updated magnitude signal. The integration circuitry may generate the modulated carrier wave based upon the updated polarity signal and the updated magnitude signal.

The integration circuitry may include a programmable current source configured: when the polarity signal has a first logic value, to source a current having a magnitude set based upon the updated magnitude signal to an integration input to produce an output integration voltage; and when the polarity signal has a second logic value, to sink a current having a magnitude set based upon the updated magnitude signal from the integration input to produce the output integration voltage. An operational-amplifier may be configured into an integration feedback topology to produce the modulated carrier wave based upon the integration voltage.

The programmable current source may include a programmable current source circuit comprising a plurality of current sources and configured to activate a number of the plurality of current sources that is dependent upon the updated magnitude signal to thereby source a current having a magnitude set based upon the updated magnitude signal to the integration input; and a programmable current sink circuit comprising a plurality of current sinks and configured to activate a number of the plurality of current sinks that is dependent upon the updated magnitude signal to thereby sink a current having a magnitude set based upon the updated magnitude signal from the integration input.

The programmable current source circuit may also include a first plurality of switches, each associated with a different one of the first plurality of current sources, with activation of a given one of the plurality of current sources being performed by closing of a corresponding switch of the first plurality of switches. The programmable current sink circuit may further include a second plurality of switches, each associated with a different one of the plurality of current sinks, with activation of a given one of the plurality of current sinks being performed by closing of a corresponding switch of the second plurality of switches.

The programmable current source circuit may activate the number of the plurality of current sources based upon a logical combination of the updated magnitude signal and the polarity signal, and the programmable current sink circuit may activate the number of the plurality of current sinks based upon a logical combination of the updated magnitude signal and the polarity signal.

A switch circuit may be configured to connect the activated number of the plurality of current sources to the integration input when the polarity signal has the first logic value, but to connect the activated number of the plurality of current sinks to the integration input when the polarity signal has the second logic value.

The programmable current source may include a programmable current source circuit with: a first current source configured to source a first current to a first node; and a first plurality of current sources configured to be selectively coupled to the first node, with a number of the first plurality of current sources being coupled to the first node being dependent upon the updated magnitude signal to thereby source a current having a magnitude set based upon the updated magnitude signal to the first node. A programmable current sink circuit may include: a second current sink configured to source a second current from a second node; and a second plurality of current sinks configured to be selectively coupled to the second node, with a number of the second plurality of current sinks being coupled to the second node being dependent upon the updated magnitude signal to thereby sink a current having a magnitude set based upon the updated magnitude signal from the second node. A switch circuit may be configured to connect the first node to the integration input when the polarity signal has the first logic value, but to connect the second node to the integration input when the polarity signal has the second logic value.

The programmable current source may include a programmable current source circuit with: a first cascode current mirror configured to have a reference current sunk from its input and to mirror the reference current to its output; a plurality of first cascode transistor circuits in a mirror arrangement with the first cascode current mirror; and a first plurality of switches, each associated with a different one of the plurality of first cascode transistor circuits and configured to be selectively closed dependent upon the updated magnitude signal to thereby source a current having a magnitude set based upon the updated magnitude signal to a first node. A programmable current sink circuit may include: a second cascode current mirror configured to receive the mirrored reference current at its input; a plurality of second cascode transistor circuits in a mirror arrangement with the second cascode current mirror; and a second plurality of switches, each associated with a different one of the plurality of second cascode transistor circuits and configured to be selectively closed dependent upon the updated magnitude signal to thereby sink a current having a magnitude set based upon the updated magnitude signal from a second node. A switch circuit may be configured to connect the first node to the integration input when the polarity signal has the first logic value, but to connect the second node to the integration input when the polarity signal has the second logic value.

A voltage regulator arrangement may be configured to generate the reference current and sink the reference current from the input of the first cascode current mirror.

A diode coupled transistor may selectively be coupled to the first cascode current mirror to adjust an average current in the first cascode current mirror.

The magnitude generation circuitry may include a look-up circuit that looks-up a value to use as the updated magnitude signal based upon the new top count value.

The integration circuitry may include a constant peak-to-peak voltage, variable period sawtooth carrier generation circuit with a programmable current source having: a first current source configured to source a first current to a first node; and a plurality of current sources configured to be selectively coupled to the first node by respective switches so as to, in combination with the first current, source a current to the first node having a magnitude set based upon the updated magnitude signal. An integration capacitor is connected between the first node and ground. A switch is connected between the first node and ground and configured to close when the polarity signal is asserted. The operation of the sourcing of the current to the first node having a magnitude set based upon the updated magnitude signal, together with discharging of the integration capacitor to ground through closing of the switch upon assertion of the polarity signal, may serve to generate the constant peak-to-peak voltage, variable period sawtooth carrier generation circuit.

The noise shaping circuitry may include: an input summer configured to subtract an error signal from the modulating wave to produce a quantizer input signal; a quantizer receiving the quantizer input signal and configured to divide the quantizer input signal by a scaling factor to produce the noise shaping output, and to multiply the noise shaping output by the scaling factor to product a quantizer output signal; an error summer configured to subtract the quantizer input signal from the quantizer output signal to produce an intermediate output; and a noise shaping filter configured to apply a noise shaping filter function to the intermediate output to produce the error signal.

The quantizer input signal and quantizer output signal may be digital, and the quantizer may be implemented digitally.

The noise shaping filter may be a finite impulse response filter.

The noise shaping filter may be a binomial FIR filter configuration with coefficients arranged in an interleaved fashion, characterized by insertion of zero-value coefficients between binomial coefficients derived from Pascal's triangle.

A dither generator may be configured to generate a dither signal having a range defined by the scaling factor, and the dither signal may be injected into the quantizer input signal prior to quantization thereof by the quantizer.

The noise shaping circuitry may include: a sigma delta modulator configured to receive the modulating wave and a quantizer output signal as input and apply a two-input one-output filtering thereto to produce a quantizer input signal; and a quantizer receiving the quantizer input signal and configured to divide the quantizer input signal by a scaling factor to produce the noise shaping output, and to multiply the noise shaping output by the scaling factor to product the quantizer output signal.

The noise shaping circuitry may be configured to be activated to produce the new noise shaping output only when the updated polarity signal is positive.

The noise shaping circuitry may be configured to be activated to produce the new noise shaping output only when the updated polarity signal is negative.

The integration circuitry may be implemented digitally.

The integration circuitry may be implemented digitally to produce the modulated carrier wave as a sawtooth waveform or a triangular waveform.

The digitally implemented integration circuitry may include: an edge detector configured to detect edges of the polarity signal; a first multiplexer configured to output either a positive logic value or a negative logic value, based upon the polarity signal; a second multiplexer configured to output either the output of the first multiplexer or a delayed version of the modulated carrier wave, based upon the detected edge of the polarity signal. A third multiplexer may be configured to output either a negative version of the magnitude signal or the magnitude signal, based upon the polarity signal. A digital summer may be configured to sum output of the second multiplexer and output of the third multiplexer to produce the modulated carrier wave.

During operation to perform positive integration, the polarity signal may be at a logic one, so that the triangular carrier is generated by the digital summer as a sum of a positive version of the magnitude signal as output by the third multiplexer and a delayed version of the modulated carrier wave, and when the edge detector detects a next edge of the polarity signal, the triangular carrier may be generated by the digital summer as the sum of the negative version of the magnitude signal and the positive logic value, thereby generating the modulated carrier wave as having a variable period but a constant peak-to-peak voltage.

During operation to perform negative integration, the polarity signal may be at a logic zero, so that the triangular carrier is generated by the digital summer as a sum of the negative version of the magnitude signal as output by the third multiplexer and the delayed version of the modulated carrier wave.

When the edge detector detects a next edge of the polarity signal, the triangular carrier may be generated by the digital summer as the sum of the positive version of the magnitude signal and the negative logic value, thereby generating the modulated carrier wave as a modulated triangular carrier wave having the variable period but the constant peak-to-peak voltage.

The digitally implemented integration circuitry may include, to perform positive integration: an edge detector configured to detect edges of the polarity signal; a digital summer configured to sum the magnitude signal and a delayed version of the modulated carrier wave to produce an intermediate output; and a multiplexer configured to output the intermediate output unless the edge detector detects an edge, at which point the multiplexer outputs a negative logic value, thereby generating the modulated carrier wave as a modulated sawtooth carrier wave having the variable period but the constant peak-to-peak voltage.

The digitally implemented integration circuitry may include, to perform negative integration: an edge detector configured to detect edges of the polarity signal; a digital summer configured to subtract the magnitude signal from a delayed version of the modulated carrier wave to produce an intermediate output; and a multiplexer configured to output the intermediate output unless the edge detector detects an edge, at which point the multiplexer outputs a positive logic value, thereby generating the modulated carrier wave as a modulated sawtooth carrier wave having the variable period but the constant peak-to-peak voltage.

The fundamental period of the carrier wave represented by the programmable constant may be dependent upon a clock used to clock the carrier generation circuitry.

BRIEF DESCRIPTION OF THE DRAWINGS

FIG. 1 is an exemplary diagram of a conventional class-D amplifier.

FIG. 2 is an exemplary diagram of the frequency spectrum of the PWM signal generated in the conventional class-D amplifier.

FIG. 3 is an exemplary diagram of a spread spectrum PWM signal generated for a class-D amplifier disclosed herein.

FIG. 4 is an exemplary diagram of a constant peak-to-peak voltage, variable period triangular carrier wave used in the class-D amplifier disclosed herein to generate the spread spectrum PWM signal illustrated in FIG. 3.

FIG. 5 is an exemplary diagram of a sample triangular modulating waveform.

FIG. 6 is an exemplary diagram of the class-D amplifier disclosed herein.

FIG. 7A is an exemplary diagram illustrating the noise shaping filter of a quantizer described herein, the noise shaping filter utilizing error feedback.

FIG. 7B is an exemplary diagram illustrating the noise shaping filter of a quantizer described herein, the noise shaping filter utilizing error feedback and an interleaved filter.

FIG. 8A is an exemplary diagram illustrating the noise shaping filter of a quantizer described herein, the noise shaping filter utilizing sigma delta modulation.

FIG. 8B is an exemplary diagram illustrating the noise shaping filter of a quantizer described herein, the noise shaping filter utilizing sigma delta modulation with an interleaved filtering arrangement.

FIG. 9 is an exemplary diagram of a first embodiment of the integrator and programmable current source disclosed herein.

FIG. 10 is an exemplary diagram of a second embodiment of the integrator and programmable current source disclosed herein.

FIG. 11 is an exemplary diagram of a third embodiment of the integrator and programmable current source disclosed herein.

FIG. 12 is an exemplary diagram of a fourth embodiment of the integrator and programmable current source disclosed herein.

FIG. 13 is an exemplary diagram of a second embodiment of a class-D amplifier disclosed herein which utilizes a capacitor circuit to generate a constant peak-to-peak voltage, variable period sawtooth carrier.

FIG. 14 is an exemplary diagram illustrating voltages of the capacitor circuit of FIG. 11 in operation.

FIG. 15 is an exemplary diagram illustrating a digital implementation of the integrator of FIG. 7A.

FIG. 16 is an exemplary plot illustrating a sample triangular carrier generated by the digital integrator implementation of FIG. 15.

FIG. 17 is an exemplary diagram illustrating a digital implementation of the integrator of FIG. 13 when configured for positive integration.

FIG. 18 is an exemplary diagram illustrating a sample sawtooth carrier generated by the digital integrator of FIG. 17.

FIG. 19 is an exemplary diagram illustrating a digital implementation of the integrator of FIG. 13 when configured for negative integration.

FIG. 20 is an exemplary diagram illustrating a sample sawtooth carrier generated by the digital integrator implementation of FIG. 19.

DETAILED DESCRIPTION

The following disclosure enables a person skilled in the art to make and use the subject matter described herein. The general principles outlined in this disclosure can be applied to embodiments and applications other than those detailed above without departing from the spirit and scope of this disclosure. It is not intended to limit this disclosure to the embodiments shown, but to accord it the widest scope consistent with the principles and features disclosed or suggested herein. Note that in the following description, any resistor or resistance mentioned is a discrete device, unless stated otherwise, and is not simply an electrical lead between two points. Therefore, any resistor or resistance connected between two points has a higher resistance than a lead between those two points, and such resistor or resistance cannot be interpreted as a lead. Similarly, any capacitor or capacitance mentioned is a discrete device or implemented with an ASIC, unless stated otherwise, and is not a parasitic element, unless stated otherwise.

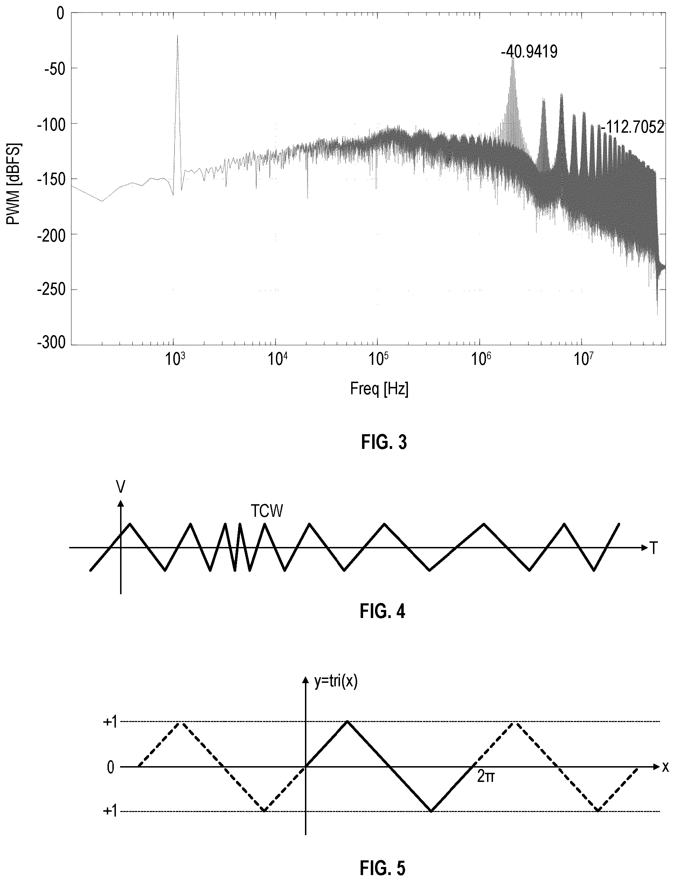

Consider now the frequency spectrum of the PWM waveform shown in FIG. 3. In this illustration, the spectrum of the PWM signal has been deliberately spread through a spread spectrum technique described in detail hereinbelow, resulting in a diminished -40.9 dBFS spike from the carrier's fundamental frequency. More notably, the spread spectrum method significantly reduces the intensity of the spikes from the harmonics-for instance, a previous -100.4 dBFS spike at $10^7$ Hz is now lowered to -112.7 dBFS. This dispersion of spectral energy over a broader range of frequencies leads to a considerable reduction in EMI, showcasing the effectiveness of the spectrum spreading described herein in mitigating interference issues in class-D amplifiers.

The spread spectrum PWM signal is generated utilizing a constant peak-to-peak voltage, variable period triangular carrier signal TCW for comparison with the filtered/compensated signal V_Fil in the class-D amplifier. An example such a constant peak-to-peak voltage, variable period triangular carrier signal TCW is shown in FIG. 4.

The theory behind the generation of a triangular carrier is now discussed. The generation of a triangular carrier wave is achieved through a modulation process which ideally requires a continuous-time triangular signal, for example having a 40 kHz frequency. This modulation results in a signal *modcarrier(t),* which is expressed as:

$$modcarrier(t) = A_c tri\big(2\pi\big(f_c + k_M tri(2\pi f_M t)\big)t\big)$$

where

- $A_c$ represents the amplitude of the carrier signal, normalized to unity for simplicity; - the term $k_M tri(2\pi f_M t)$ is the modulating waveform,
- with $f_M$ set to 40 kHz, which modulates the carrier frequency $f_c$, set to 2.3 MHz;
- the modulation index $k_M$, dictates the maximum frequency displacement, which results in the instantaneous frequency being $f_c + k_M$.

A graph of a sample triangular modulating waveform y=tri(x) may be observed in FIG. 5.

To simplify the implementation, the frequency modulation (FM) can be transformed into period modulation (PM), wherein the modulated carrier *modcarrier(t)* is mathematically rearranged as:

$$modcarrier(t) = A_c tri(2\pi(f_c')t)$$

This transformation is achieved by integrating a rectangular function $rect(2\pi(f_c')t)$, representing the instantaneous frequency $f_c'$, which is in turn derived from the carrier frequency $f_c$ and the frequency displacement $\Delta f$ as $f_c', = f_0 + \Delta f$, where $f_0 = f_c$.

The instantaneous frequency $f_c'$ is related to the instantaneous period $T_c'$ by a Taylor approximation:

$$T_c' = T_c + k_{pm} tri(2\pi f_m t)$$

$$k_{pm} = \left(-1/{f_c}^2\right) k_m$$

where $T_c$ 1/$f_c$ is the carrier period and $k_{pm} = \left(-1/{f_c}^2\right) k_m$ is the period modulation index.

The final step in the generation process is the time discretization of the modulating triangle wave, $k_{pm} tri(2\pi f_m t)$, which is based on the system clock frequency $f_{clk}$, here given as 64.5 MHz. This discretization is essential for digital implementation of the modulation process.

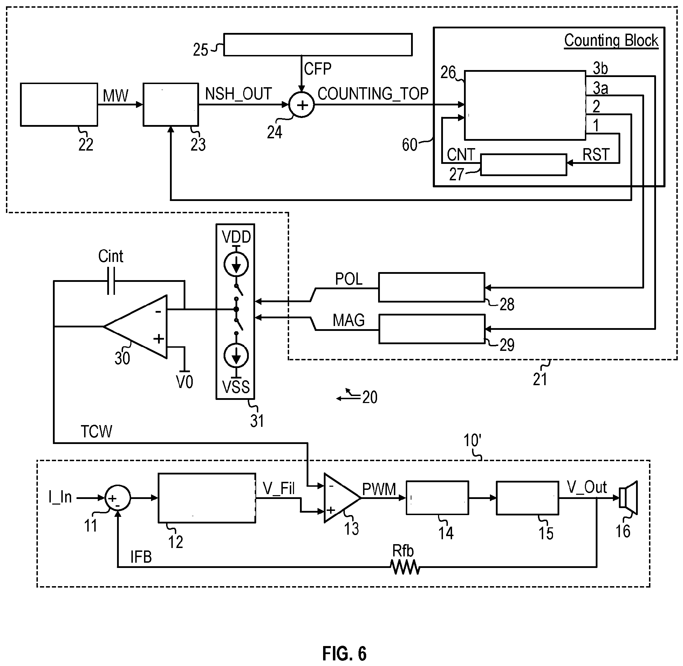

With the theory behind the generation of the triangular carrier wave having been explained, now described with reference to FIG. 6 is a class-D amplifier 10' disclosed herein, with a carrier generation circuit 20 that generates a constant peak-to-peak voltage, variable period triangular carrier signal (such as that shown in FIG. 4) for use by the class-D amplifier 10' in generating its PWM signal.

The carrier generation circuit 20 includes an amplifier 30 having its non-inverting input connected to a voltage reference V0 (e.g., ground or another reference value), its inverting input coupled to programmable current source 31. An integration capacitor Cint is connected between the non-inverting input of the amplifier 30 and the output of the amplifier 30, and the constant peak-to-peak voltage, variable period triangular carrier signal TCW is produced at the output of the amplifier 30. In operation, the programmable current source 31 selectively sources or sinks currents of different magnitudes to or from the inverting input of the amplifier 30 in such a fashion that the triangular carrier signal TCW produced at the output of the amplifier 30 has a constant peak-to-peak voltage but a variable period. The polarity of the programmable current source 31 (e.g., whether the programmable current source 31 sinks current from the inverting input of the amplifier 30 or sources current to the inverting input of the amplifier 30) is set by a polarity signal POL, and the magnitude of the current sunk or sourced by the programmable current source 31 is set by a magnitude signal MAG.

A control signal generator 21 in the carrier generation circuit 20 generates the polarity signal POL and magnitude signal MAG. The control signal generator 21 may be implemented digitally in a microprocessor or application specific integrated circuit (ASIC), and includes modulation circuitry 22 for generating a modulating wave MW that in this example has a frequency on the order of 40 KHz, but may have any suitable frequency; the modulating wave MW may be triangular, sinusoidal, cubic, etc. The modulating wave MW is noise shaped by a noise shaper 23 to produce a noise shaped output NSH_OUT, which is limited to being one of a set of discrete values.

For example, in one embodiment, the value of the noise shaped output NSH_OUT in a given iteration may be selected from among -2, -1, 0, 1, or 2. This noise shaped output NSH_OUT is then added by adder 24 to value CFP which represents one half of a fundamental period of a generated (e.g., in block 25) carrier wave, divided by the period of the clock used to generate the carrier wave. In this example, the carrier wave has a frequency on the order of 2.3 MHz, corresponding to a period of 434ns. Note that value CFP itself can be configured through modification of the period modulation index $k_{pm}$ and the modulation period frequency $f_m$ of the modulating wave MW - in the case of a triangular modulating wave, this means changing the input peak and frequency - together with corresponding changes to the integrator 30.

In the illustrated example of FIG. 6, the carrier wave is generated from a 64.5 MHz clock, corresponding to a period of 15.5ns. One half the period of the carrier wave is 217ns, and therefore the number of clock cycles in the carrier wave half period is 14. As such, one half of the fundamental period of the generated carrier wave can be represented as a fixed constant CFP equal to 14. Stated otherwise, value CFP is a constant calculated as:

$$CFP = \left(\frac{1}{2} \cdot T_{carrier}\right) \Big/ T_{CLK}$$

where $T_{carrier}$ is the period of the carrier wave, and
$T_{CLK}$ is the period of the clock used to generate the wave.

Regarding the frequency of the carrier wave, the carrier wave frequency is to be higher than a desired band (as a nonlimiting example, the audio band of nominally 20 kHz) at open loop, and at closed loop, the carrier wave frequency is to be higher (and with a sufficient margin) than the cut-off frequency of the filter 12, and the central frequency is to be outside of regulatory electromagnetic compatibility (EMC) frequency masks where possible.

The result of the addition of NSH_OUT and CFP is COUNTING_TOP, which serves to set a maximum count value for an up-counter 27 within a counting block 60, the up-counter 27 controlled by a reset signal RST (also labelled as signal 1) from a control signal generation circuit 26 within the counting block 60 (the control signal generation circuit 26 monitoring the current count value CNT). COUNTING_TOP may therefore in this example assume the values of 12, 13, 14, 15, or 16 during operation.

Note that the noise shaper 23 is activated to generate a new value of NSH_OUT (resulting in a new value of COUNTING_TOP being generated) when current count value CNT of the up-counter 27 has reached the previous value of COUNTING_TOP, at which time the control signal generation circuit 26 asserts the reset signal RST (signal 1) to reset the up-counter 27 and so that the control signal generation circuit 26 provides the current value of COUNTING_TOP to polarity determination circuitry 28 (as signal 3a) and look-up circuitry 29 (as signal 3b). As an alternative, the noise shaper 23 may be activated (by signal 2 generated by the control signal generation circuit 26) to generate the new value of NSH_OUT only when the next polarity is positive (or negative), providing for the new COUNTING_TOP calculation to be performed only once per period, thereby producing two equivalent duration carrier edges.

The polarity determination circuit 28 treats COUNTING_TOP as a toggle or flip signal, with each newly received value of COUNTING_TOP from the counting block 60 causing the polarity determination circuit 28 toggle the polarity signal POL - if the polarity signal POL was previously set such to cause the programmable current source 31 to sink current from the inverting input terminal of the amplifier 30, upon receipt of the new value of COUNTING_TOP from the counting block 60, the polarity determination circuit 28 sets the polarity signal to cause the programmable current source 31 to source current to the inverting input terminal of the amplifier 30.

The higher the new value of COUNTING_TOP received from the counting block 60, the lower the magnitude signal MAG retrieved from a look-up table by the look-up circuitry; conversely, the lower the new value of COUNTING_TOP received from the counting block 60, the higher the magnitude signal MAG retrieved from a look-up table by the look-up circuitry 29. This is because the output of the amplifier 30 is to have a constant peak-to-peak voltage, therefore a lower value of COUNTING_TOP indicates that the programmable current source 31 is to source or sink a current with a higher magnitude to or from the inverting input of the amplifier 30 so as to more quickly charge or discharge the integration capacitor Cint within the limited time available, while a higher value of COUNTING_TOP indicates that the programmable current source 31 is to source or sink a current with a lower magnitude to or from the inverting input of the amplifier 30 so as to less quickly charge or discharge the integration capacitor Cint within the longer time available. Through this toggling of the polarity signal POL and changing of the magnitude signal MAG, the resulting change in operation of the programmable current source 31 causes the generation of the variable period, constant peak-to-peak carrier (e.g., triangular carrier) produced by the amplifier 30.

Example values of the current to be sunk or sourced by the programmable current source 31, and the resulting peak-to-peak voltage of the variable period, constant peak-to-peak carrier produced by the amplifier 30 in turn are summarized in Table I that follows.

TABLE I

| COUNTING_TOP | Current Magnitude | Peak-to-Peak Signal Produced by Amplifier |
| --- | --- | --- |
| 12 | 35µA | 1.3V |
| 13 | 32.3µA | 1.3V |
| 14 | 30µA | 1.3V |
| 15 | 28µA | 1.3V |
| 16 | 26.3µA | 1.3V |

The class-D amplifier 10' exemplified in Figure 6 includes the voltage summing block 11 that processes a differential signal by subtracting a feedback current IFB from an input signal I_In, with the resulting signal being filtered by a filter and compensation circuit 12 to produce a filtered/compensated signal V_Fil. A comparator or PWM modulator 13 compares the filtered/compensated signal V_Fil at its non-inverting input to the variable period, constant peak-to-peak carrier provided to its inverting input by the amplifier 30 to produce a spread spectrum pulse-width modulation signal PWM that mirrors the amplitude variations of the input signal I_In over time. The signal PWM is then used to control the transistors in an H-bridge circuit 14 (or a full bridge circuit), generating an amplified signal that is filtered by LC filter 15 to smooth out high-frequency components resulting from the PWM, reconstructing an analog signal V_Out. This resulting analog signal V_Out may then, in the instance where it is an analog audio signal, be passed to a loudspeaker 16, which converts it back into audible sound waves.

Details of noise shaping circuitry that may be used, such as an error-feedback type noise shaper, are contained in United States Application for Patent No. 17/846,520, filed June 22, 2022, the contents of which are incorporated by reference in their entirety.

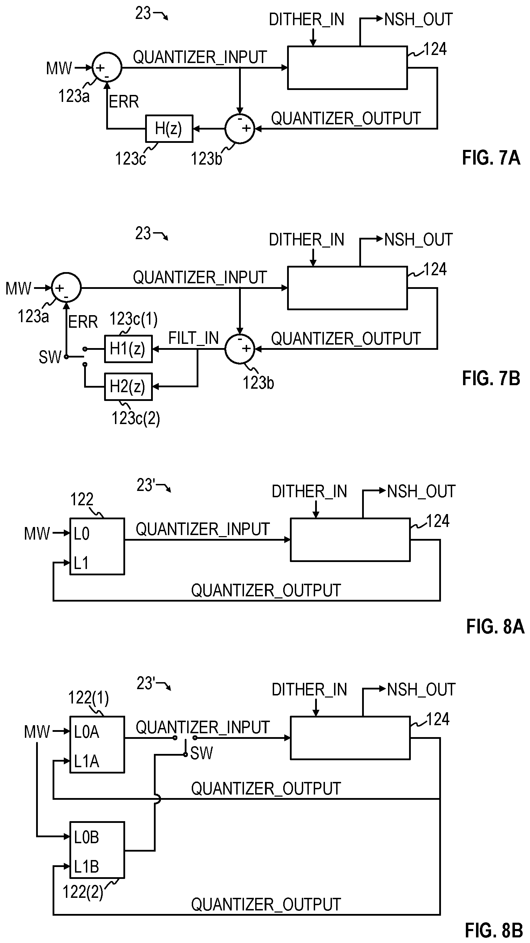

As exemplified herein, the noise shaping filter 23 used in the above-described embodiments may utilize error feedback or sigma-delta modulation. Now described with reference to FIG. 7A is an embodiment of the noise shaping filter 23 utilizing error feedback and designed to work with a (e.g., digital) quantizer 124. The noise shaping filter 23 includes an input summer 123a that subtracts an error signal ERR output by a noise shaping filter 123c from the noise shaping input signal MW to produce the quantizer input QUANTIZER_INPUT. The digital quantizer 124 injects the dither signal DITHER_IN to the quantizer input QUANTIZER_INPUT and divides the quantizer input QUANTIZER_INPUT by scaling factor $\gamma$, with that result being truncated such as by a rounding, floor, or ceiling function to produce the noise shaping output signal NSH_OUT. The digital quantizer 124 multiplies the noise shaping output signal NSH_OUT to produce the quantizer output QUANTIZER_OUTPUT. An error summer 123b subtracts the quantizer input QUANTIZER_INPUT from the quantizer output QUANTIZER_INPUT and provides the result to the noise shaping filter 123c which has a transfer function of H(z). The noise shaping filter 123c produces the error signal ERR as output, and may be a binomial Finite Impulse Response (FIR) filter. With a binomial FIR filter, the binomial coefficients offer a convenient way to shape the spectral characteristics of the quantization noise. For instance, by adopting a binomial FIR filter design, the noise shaping filter 123c can effectively manage the rise and fall times within a given semi-period of the output signal.

Greater details of the use of a binomial based FIR filter are now provided. This is a FIR filter that uses coefficients derived from the binomial theorem and Pascal's triangle, albeit with a specific modification process. The binomial theorem provides a way to expand expressions that are raised to a power, expressed as:

$$(a + b)^n = \sum_{k=0}^{n} \binom{n}{k} a^{n-k} b^k$$

Here, $\binom{n}{k}$ are the binomial coefficients, which can also be found in Pascal's Triangle. Each row in Pascal's Triangle corresponds to the coefficients of $(a + b)^n$, starting from n = 0. These coefficients are symmetric and have the property where the sum of all elements in a row is $2^n$. For the binomial FIR filter, coefficients are derived with specific modifications from a selected row in Pascal's triangle:

Select a row from Pascal's triangle. This row number corresponds to the order n of the binomial expansion. The first element (which is always 1) is substituted with 0. The signs of the coefficients are alternated starting from the second term. This alternating pattern of signs will affect the phase and frequency response of the filter.

Row 0 in Pascal's Triangle: 1; Modified to FIR coefficients, Row 0 is: 0
Row 1 in Pascal's Triangle: 1, 1; Modified to FIR coefficients, Row 1 is 0,1
Row 2 in Pascal's Triangle: 1, 2, 1; Modified to FIR coefficients, Row 2 is 0, 2, -1
Row 3 in Pascal's Triangle: 1, 3, 3, 1; Modified to FIR coefficients: 0, 3, - 3, 1
Row 4 in Pascal's Triangle: 1, 4, 6, 4, 1; Modified to FIR coefficients: 0, 4, -6, 4, -1

An example chart highlighting this is summarized in Table II below.

TABLE II

| Order | Coefficients | Packed Form |
|---|---|---|
| 1 | $z^{-1}$ | [0 1] |
| 2 | $2z^{-1} - 1z^{-2}$ | [0 2 -1] |
| 3 | $3z^{-1} - 3z^{-2} + 1z^{-3}$ | [0 3 -3 1] |
| 4 | $4z^{-1} - 6z^{-2} + 4z^{-3} - 1z^{-4}$ | [0 4 -6 4 -1] |

Other options for the noise shaper 23 include an error feedback arrangement with a FIR filter. This arrangement is the same as in FIG. 7A, but with the coefficients of the noise shaping filter 123c being [0 c1 c2 c3 c4 ...] Another option for the noise shaper 23 includes an error feedback arrangement, as in FIG. 7A, but a generic noise shaping filter 123c (e.g., IIR, Biquad, etc). A further option for the noise shaper 23 is an error feedback arrangement with an interleaved FIR filter, which provides the possibility to separately influence the current rise and fall semi-periods of the output signal waveform by using past error values that are exclusive to rise or fall edges of the waveform. This arrangement is the same as in FIG. 7A, but with the coefficients of the noise shaping filter 123 being [0 c1 0 c2 0 c3 0 c4 0 ...].

Another option for the noise shaper 23 includes an error feedback arrangement with a generic filtering function that is interleaved. Refer now to FIG. 7B, which is similar to the error feedback arrangement of FIG. 7A, but where two noise shaping filters 123c(1) and 123c(2) may be selected from. When the polarity signal POL is set to rise, switch SW connects noise shaping filter 123c(1) between error summer 123(b) and input summer 123(a). Conversely, when the polarity signal POL is set to fall, switch SW connects noise shaping filter 123c(2) between error summer 123(b) and input summer 123(a).

Now described with reference to FIG. 8A is an embodiment of the noise shaping filter 23' in which the noise shaping filter is implemented as a sigma-delta modulator 122, and designed to work with a digital quantizer 124. The sigma-delta modulator 122 includes a U-input (L0) that receives the noise shaping input MW and a V-input (L1) that receives the quantizer output QUANTIZER_OUTPUT and the output of the sigma-delta modulator 122 is the quantizer input QUANTIZER_INPUT. The sigma-delta modulator 122 applies a two-input, one output filtering according to the equation $Y(z)=L0(z)U(z)-L1(z)V(z)$. The quantizer input QUANTIZER_INPUT may be produced as a digital signal for use with the digital quantizer 124.

Another option for the noise shaper 23' includes sigma-delta modulator arrangement with a generic filtering function that is interleaved. Refer now to FIG. 8B, which is similar to the sigma-delta modulator arrangement of FIG. 8A, but where two sigma-delta modulators 122(1) and 122(2) may be selected from. When the polarity signal POL is set to rise, switch SW connects the output of sigma-delta modulator 122(1) to the input of the quantizer 124, and when the polarity signal POL is set to fall, the switch SW connects the output of the sigma-delta modulator 122(2) to the input of the quantizer 124.

Sample sigma-delta modulator designs such as may be used in the embodiment of FIGS. 8A-8B may be found in Understanding Delta-Sigma Delta Data Converters, Pavan, Shanthi; Schreir, Richard; Temes, Gabor C., IEEE Press Series on Microelectronic Systems, IEEE 2017, the contents of which are incorporated by reference.

Sample analog circuit embodiments for the programmable current source 31 are now described.

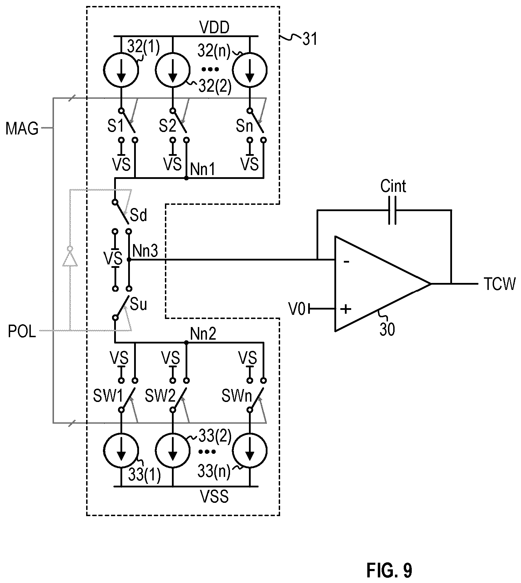

Refer first to FIG. 9, in which the programmable current source 31 includes n current source/switch pairs 32(1)/S1, 32(2)/S2, ..., 32(n)/Sn coupled between a supply voltage VDD and node Nn1, n current sink/switch pairs 33(1)/SW1, 33(2)/SW2, ..., 33(n)/SWn coupled between node Nn2 and VSS, and switches Sd, Su to selectively connect either the n current source/switch pairs 32(1)/S1, 32(2)/S2, ..., 32(n)/Sn to the inverting input of the amplifier 30 at node Nn3 or the n current sink/switch pairs 33(1)/SW1, 33(2)/SW2, ..., 33(n)/SWn to the inverting input of the amplifier 30 at node Nn3.

As exemplified herein, current source 32(1) is selectively connected either to a reference voltage VS or node Nn1 by switch S1, current source 32(2) is selectively connected either to VS or node Nn1 by switch S2, and so on for each of the n current source/switch pairs, with current source 32(n) being selectively connected either to VS or node Nn1 by switch Sn. Current sink 33(1) is selectively connected either to VS or node Nn2 by switch SW1, current sink 33(2) is selectively connected either to VS or node Nn2 by switch SW2, and so on for each of the n current sink/switch pairs, with current sink 33(n) being selectively connected either to VS or node Nn2 by switch SWn. Switch Sd selectively connects node Nn1 to either node Nn3 or VS, and switch Su selectively connects node Nn2 to either node Nn3 or VS.

Current source 32(1) sources a first current (e.g., 26.3 μA) to node Nn1 when switch S1 is actuated so as to permit current flow to node Nn1, current source 32(2) sources a second current (e.g., 28μA) to node Nn1 when switch S2 is actuated so as to permit current flow to node Nn1, and current source 32(3) (where n=3) sources a 3rd current (e.g., 30μA) to node Nn1 when switch S3 is actuated so as to permit current flow to Nn1. Current sink 33(1) sinks the first current (e.g., 26.3μA) from node Nn2 when switch SW1 is actuated so as to permit current sinking from node Nn2, current sink 33(2) sinks the second current (e.g., 28μA) from node Nn2 when switch SW2 is actuated so as to permit current sinking from node Nn2, and current sink 33(3) (where n=3) sinks the 3rd current (e.g., 28μA) from node Nn2 when switch SW3 is actuated so as to permit current sinking from node Nn2. Note that in FIG. 9, n is a generic integer value, and therefore there may be any number of current sources 32(1), ..., 32(n) and any number of current sinks 33(1), ..., 31(n).

Switches S1-Sn, SW1-SWn are controlled by the magnitude signal MAG, and switches Sd, Su are alternatingly controlled by the polarity signal POL.

In operation therefore, when the polarity signal POL is at a first logic value, switch Sd is actuated to permit sourcing of current to node Nn3 and switch Su is open, and the value of the magnitude signal MAG which of switches S1, ..., Sn is actuated to permit current flow (e.g., which of the current sources 32(1), ..., 32(n) is sourcing current to node Nn1). Recall the example where COUNTING_TOP is between 13 and 15 and n=3. In this example, when the value of COUNTING_TOP is 15, switch S1 is actuated so that current source 32(1) sources current to node Nn1; when the value of COUNTING_TOP is 14, switch S2 is actuated so that current source 32(2) sources current to node Nn1; and when the value of COUNTING_TOP is 13, switch S3 (where n=3) is actuated so that current source 32(3) sources current to node Nn1.

Conversely, when the polarity signal POL is at a second logic value, switch Su is actuated to sink current from node Nn3 while switch Sd is open, and the value of the magnitude signal MAG determines which of switches SW1, ..., SWn are is actuated to permit sinking of current from node Nn2 (e.g., which of the current sinks 33(1), ..., 33(n) is sinking current from node Nn2). Recall again the example where COUNTINGTOP is between 13 and 15 and n=3. In this example, when the value of COUNTING_TOP is 15, switch SW1 is actuated so that current sink 33(1) sinks current from node Nn2; when the value of COUNTING_TOP is 14, switch SW2 is actuated so that current sink 33(2) sinks current from node Nn2; and when the value of COUNTING_TOP is 13, switch SW3 (where n=3) is actuated so that current source 33(3) sinks current from node Nn2.

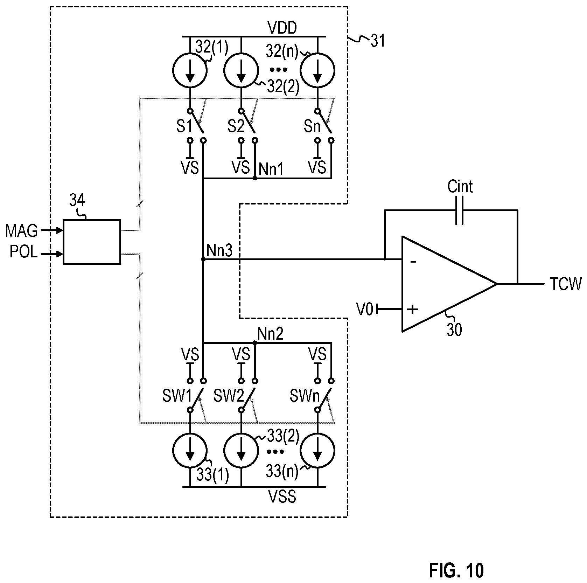

Refer now to the example of the programmable current source 31 shown in FIG. 10. The arrangement of the current source/switch pairs 32(1)/S1, 32(2)/S2, ..., 32(n)/Sn and current sink/switch pairs 33(1)/SW1, 33(2)/SW2, ..., 33(n)/SWn is the same as in FIG. 9, but switches Su and Sd are not present. Instead, nodes Nn1, Nn2, and Nn3 are directly electrically connected to one another, and a logic circuit 34 receives the magnitude signal MAG and polarity signal POL and individually controls switches S1, ..., Sn and SW1, ..., SWn to yield the desired magnitude current sourced to or sunk from node Nn3.

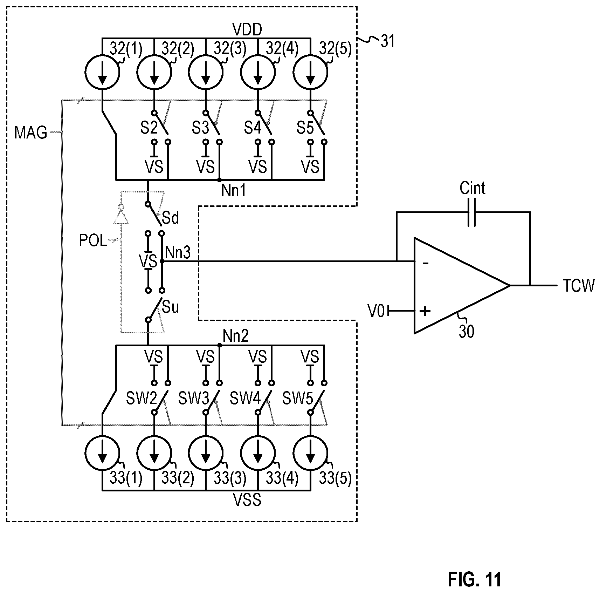

In another example of the programmable current source 31 shown in FIG. 11, the magnitude signal MAG may be in the form of a thermometer code. Here, the programmable current source 31 includes current source 32(1) directly connected to source current to node Nn1, and n-1=4 (so, n=5) current source/switch pairs 32(2)/S2, ..., 32(5)/S5 coupled between a supply voltage VDD and node Nn1, n-1=4 current sink/switch pairs 33(2)/SW2, ..., 33(5)/SW5 coupled between node Nn2 and VSS, and switches Sd, Su to selectively connect either the current source/switch pairs 32(2)/S2, ..., 32(5)/S5 to the inverting input of the amplifier 30 at node Nn3 or the current sink/switch pairs 33(2)/SW2, ..., 33(5)/SW5 to the inverting input of the amplifier 30 at node Nn3.

For example, current source 32(2) is selectively connected either to VS or node Nn1 by switch S2, current source 32(3) is selectively connected either to VS or node Nn1 by switch S3, current source 32(4) is selectively connected either to VS or node Nn1 by switch S4, and current source 32(5) is selectively connected either to VS or node Nn1 by switch S5.

Current sink 33(2) is selectively connected either to VS or node Nn2 by switch SW2, current sink 33(3) is selectively connected either to VS or node Nn2 by switch SW3, current sink 33(4) is selectively connected either to VS or node Nn2 by switch SW4, current sink 33(5) is selectively connected either to VS or node Nn2 by switch SW5.

Switch Sd selectively connects node Nn1 to either node Nn3 or VS, and switch Su selectively connects node Nn2 to either node Nn3 or VS.

The magnitude of currents sourced by current sources 32(1), ..., 32(5) and the magnitude of currents sunk by current sinks 33(1), ..., 33(5) are set according to the thermometric scale. For example, current source 32(1) may source a current of 26.3 $\mu$A, current source 32(2) may source a current of 1.7$\mu$A, current source 32(3) may source a current of 2$\mu$A, current source 32(4) may source a current of 2.3$\mu$A, and current source 32(5) may source a current of 2.7$\mu$A. Similarly, current sink 33(1) may sink a current of 26.3$\mu$A, current sink 33(2) may sink a current of 1.7$\mu$A, current sink 32(3) may sink a current of 2$\mu$A, current sink 32(4) may sink a current of 2.3$\mu$A, and current sink 32(5) may sink a current of 2.7$\mu$A.

Recall that the higher the new value of COUNTING_TOP received from the counting block 60, the lower the magnitude of the current sourced to or sunk from the inverting input of the amplifier 30, and that the lower the new value of COUNTING_TOP received from the counting block 60, the higher the magnitude of the current sourced to or sunk from the inverting input of the amplifier 30. Recall also that COUNTING_TOP may in this example assume the values of 12, 13, 14, 15, or 16 during operation, and assume that the magnitude signal MAG is a 4-bit thermometer code. Therefore, when COUNTING_TOP is 12 the magnitude signal MAG is 1111, when COUNTING_TOP is 13 the magnitude signal MAG is 1110, when COUNTING_TOP is 14 the magnitude signal MAG is 1100, when COUNTING_TOP is 15 the magnitude signal MAG is 1000, and when COUNTING_TOP is 16 the magnitude signal MAG is 0000. Therefore, when COUNTING_TOP is 12 switches S2-S5 are actuated (or switches SW2-SW5 are actuated) to permit current flow, when COUNTING_TOP is 13 switches S2-S4 are actuated (or switches SW2-SW4 are actuated) to permit current flow, when COUNTING_TOP is 14 switches S2-S3 are actuated (or switches SW2-SW3 are actuated) to permit current flow, when COUNTING_TOP is 15 switch S2 is actuated (or switch SW2 is actuated) to permit current flow, and when COUNTING_TOP is 16, none of switches S2-S5 and SW2-SW5 are actuated.

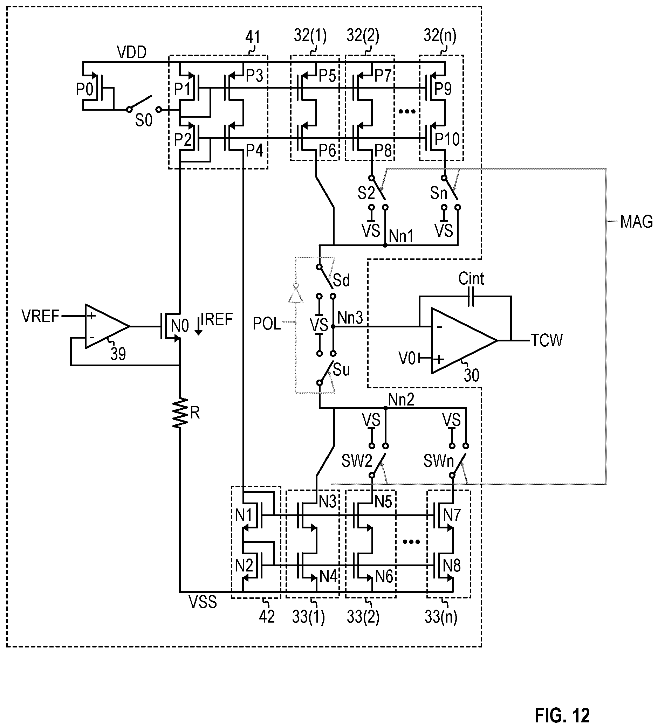

A transistor circuit version of the embodiment of the programmable current source 31 of FIG. 11 is now described with reference to FIG. 12. Here, a voltage regulator arrangement is formed by amplifier 39 and n-channel transistor N0 to sink a reference current IREF (based upon a reference voltage VREF divided by reference resistance R) from the input of cascode current mirror 41. The output of the cascode current mirror 41 is connected to the input of cascode current mirror input 42.

Cascode current mirror 41 includes p-channel transistor P1 having its source connected to VDD and its drain connected to its gate, p-channel transistor P2 having its source connected to the drain of P1 and its drain connected to its gate as well as to the drain of n-channel transistor N0, p-channel transistor P3 having its source connected to VDD, and p-channel transistor P4 having its source connected to the drain of P3. The gates of p-channel transistors P1 and P3 are connected, and the gates of p-channel transistors P2 and P4 are connected.

Cascode current mirror input 42 includes n-channel transistor N1 having its drain connected to the drain of P4 and to the gate of N1, and n-channel transistor N2 having its drain connected to the source of N1 and to the gate of N2 and its source connected to VSS.

Current source 32(1) is formed by p-channel transistors P5 and P6 connected in series between the supply voltage VDD and node Nn1, and in a current mirror arrangement with the transistors P1, P2, P3, P4 of cascode current mirror 41 (e.g., the gate of P5 is connected to the gates of P3 and P1, and the gate of P6 is connected to the gate of P4 and P2).

Current source 32(2) is formed by p-channel transistors P7 and P8 connected in series between the supply voltage VDD and switch S2, and in a current mirror arrangement with the transistors P1, P2, P3, P4 of cascode current mirror 41 (e.g., the gate of P7 is connected to the gates of P3 and P1, and the gate of P8 is connected to the gate of P4 and P2). Switch S2 selectively connects the drain of transistor P8 to either VS or node Nn1.

Current source 32(n) is formed by p-channel transistors P9 and P10 connected in series between the supply voltage VDD and switch Sn, and in a current mirror arrangement with the transistors P1, P2, P3, P4 of cascode current mirror 41 (e.g., the gate of P9 is connected to the gates of P3 and P1, and the gate of P10 is connected to the gate of P4 and P2). Switch Sn selectively connects the drain of transistor P10 to either VS or node Nn1.

In operation, when the polarity signal POL is asserted to actuate switch Sd, the current IREF is mirrored by transistors P5, P6, transistors P7, P8, or transistors P9, P10 and flows through the corresponding actuated ones of switches S2, Sn (with actuation being depending on the value of MAG) to reach node Nn1.

Current sink 33(1) is formed by p-channel transistors N3 and N4 connected in series between VSS and node Nn2, and in a current mirror arrangement with the transistors N1, N2 of cascode current mirror input 42.

Current sink 33(2) is formed by p-channel transistors N5 and N6 connected in series between VSS and switch SW2, and in a current mirror arrangement with the transistors N1, N2 of cascode current mirror input 42. Switch SW2 selectively connects the drain of transistor N5 to either VS or node Nn2.

Current sink 33(n) is formed by p-channel transistors N7 and N8 connected in series between VSS and switch SWn, and in a current mirror arrangement with the transistors N1, N2 of cascode current mirror input 42. Switch SWn selectively connects the drain of transistor N7 to either VSS or node Nn2.

When the polarity signal is asserted to actuate switch Su to permit current flow, the current IREF is mirrored and thus sunk from node Nn2 by transistors N3, N4, transistors N5, N6, or transistors N7, N8 through the corresponding actuated ones of switches SW1, SW2, SWn (with actuation being dependent on the value of MAG).

The average value of the mirrored version of IREF may be adjusted by closing switch S0 connected between the drain of transistor P1 (source of transistor P2) and the drain/gate of p-channel transistor P0 (which has its source connected to VDD).

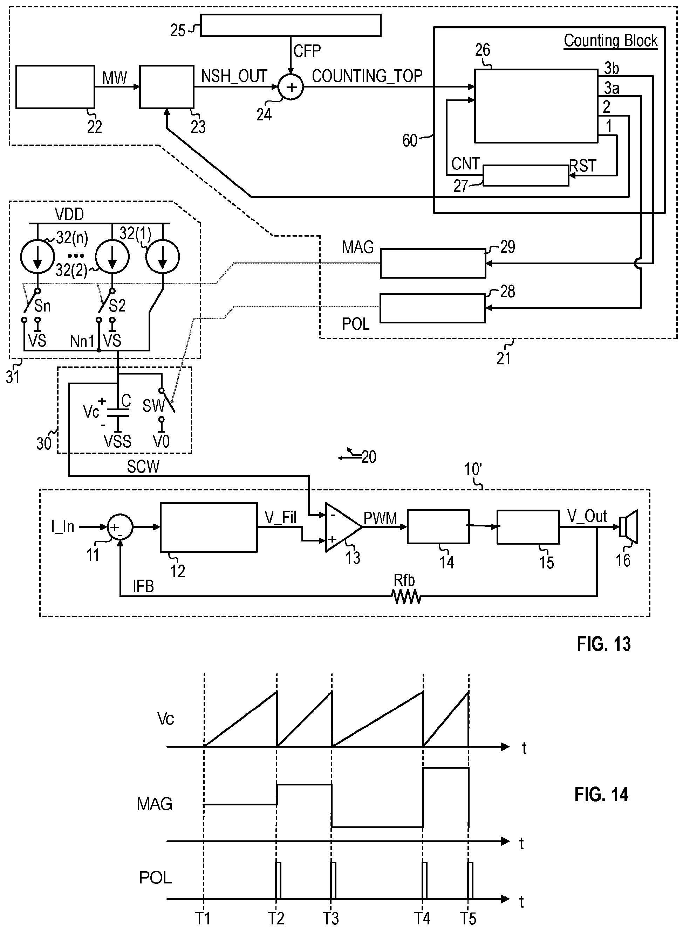

Instead of a programmable current source 31 and op-amp integrator 30 being used to generate a constant peak-to-peak voltage, variable period triangular carrier signal, a capacitor circuit may be used to generate a constant peak-to-peak voltage, variable period sawtooth carrier signal SCW, as shown in FIG. 13. The capacitor circuit includes a capacitor C connected between node Nn1 and VSS, and a switch SW is likewise connected between node Nn1 and a reference voltage V0. A current sourcing circuit is formed by n current sources 32(1), ..., 32(n), with current source 32(1) being directly connected between the supply voltage VDD and node Nn1 (assuming the magnitude signal MAG represents a thermometric code, otherwise there could be a switch S1 selectively connecting current source 32(1) to node Nn1), and the other current sources 32(2), ..., 32(n) being selectively coupled either to node Nn1 or VS by respective switches S2, ..., Sn. Switch SW is controlled by the polarity signal POL while switches S2, ..., Sn are controlled by the magnitude signal MAG. Note that a current source is not used for discharging the capacitor C here, as the switch SW is used to discharge the capacitor.

Operation to generate the constant peak-to-peak voltage, variable period sawtooth carrier signal SCW is now described with additional reference to FIG. 14. Assuming the use of the thermometric scale to dictate the sourcing and sinking of currents remains, the number of current sources 32(2), ..., 32(n) connected to node Nn1 is dependent upon the magnitude signal - where a greater magnitude is desired, more of the current sources 32(2), ..., 32(n) are connected to node Nn1 by their respective switches S2, ..., Sn being actuated by the magnitude signal MAG to permit current flow, and where a smaller magnitude is desired, less of the current sources 32(2), ..., 32(n) are connected to node Nn1 by their respective switches S2, ..., Sn being actuated by the magnitude signal MAG to permit current flow. Here, the polarity signal POL is a pulse, and serves to actuate switch SW to quickly discharge capacitor C to ground, creating the sawtooth shape SCW of the voltage Vc across the capacitor C.

Observe that at time T1 in FIG. 14, voltage Vc beings to ramp up until time T2, at which point the polarity signal POL is pulsed to quick transition the voltage Vc to ground. At time T2, the voltage Vc begins again to ramp up, with a greater slope than it ramped up between times T1 and T2 (shown by the greater value of MAG between times T2 and T3 than between times T1 and T2), and at time T3, the polarity signal POL is again pulsed to quickly transition the voltage Vc back to ground. At time T3, the voltage Vc begins to again ramp up, with a lesser slope than it ramped up with between times T1 and T2 as well as between times T2 and T3 (shown by the lesser value of MAG between times T3 and T4 than between times T1 and T2 and between times T2 and T3). At time T4, the polarity signal POL is again pulsed to quickly transition the voltage Vc back to ground.

At time T4, the voltage Vc begins to again ramp up, with a greater slope than it ramped up with between times T1 and T2 as well as between times T2 and T3 and between times T3 and T4 (shown by the greater value of MAG between times T4 and T5 than between times T1 and T2 and between times T2 and T3 as well as between times T3 and T4). At time T5, the polarity signal POL is again pulsed to quickly transition the voltage Vc back to ground.

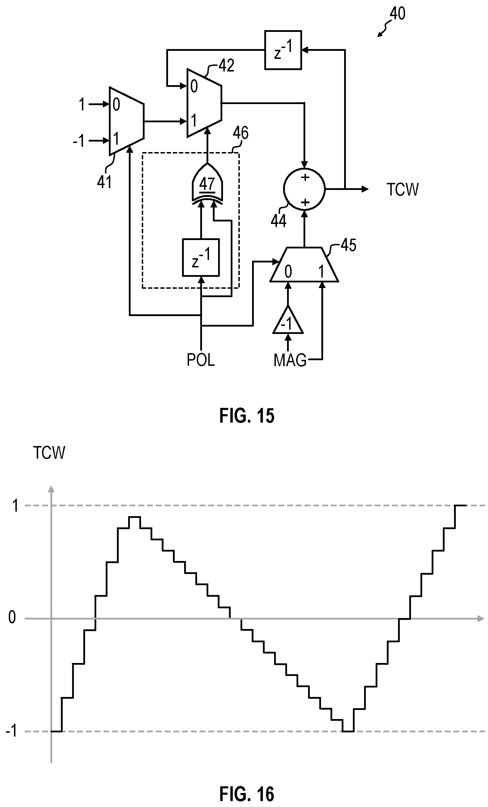

Finally, it is evident that modifications and variations can be made to what has been described and illustrated herein without departing from the scope of this disclosure. For example, as shown in FIG. 15, the integrator 40 for generating the carrier as a triangular carrier can be implemented digitally. By adding or subtracting MAG from the output, this emulates the sourcing of current to an integration capacitor or the sinking of current from the integration capacitor, which integrates as a straight-line slope. By changing the timing of how quickly the addition or subtraction occurs, the slope is changed, with the magnitude being represented by a digital number that grows or decreases by one.

As exemplified herein, the digital integrator 40 includes a first multiplexer 41 controlled by the polarity signal POL to output either a first logic value (e.g., a logic 1) or a second logic value (e.g., a logic -1), a second multiplexer 42 controlled by an edge detector 46 to output either a delayed version of the triangular carrier or the output of the first multiplexer 41, and a third multiplexer 45 controlled by the polarity signal POL to output either the magnitude signal MAG or its inverse. An adder 44 scales the output of the second multiplexer 42 by the output of the third multiplexer 45 to produce the triangular carrier. The edge detector 46 includes an XOR gate 47 that compares the polarity signal POL to a delayed version of the polarity signal POL.

In operation, the polarity signal POL is a logic 1 when the integration to be performed is positive and is a logic 0 when the integration to be performed is negative. The magnitude signal MAG, output by the control signal generator 21 of FIG. 6, indicates the size of the piece of the triangular carrier generated for each clock cycle. This triangular carrier can be seen in FIG. 16 and is perhaps best understood as a digital equivalent of the magnitude of the current output by the analog integrator 30 of FIG. 6. The lower the half-period of the triangular carrier, the higher the magnitude signal MAG, and the higher the half-period of the triangular carrier, the lower the magnitude signal MAG. If the magnitude signal MAG is insufficient to reach the peak of the triangular carrier, the edge detector 46 detects a change on the polarity signal POL and replaces the current value of the triangular carrier with the peak itself, so as to maintain the triangular carrier as having a constant peak-to-peak voltage. The magnitude signal itself MAG is, in this embodiment, always a positive integer and multiplied by -1 when the integration to be performed is negative and maintained as being a positive integer (not multiplied by -1) when the integration to be performed is positive.

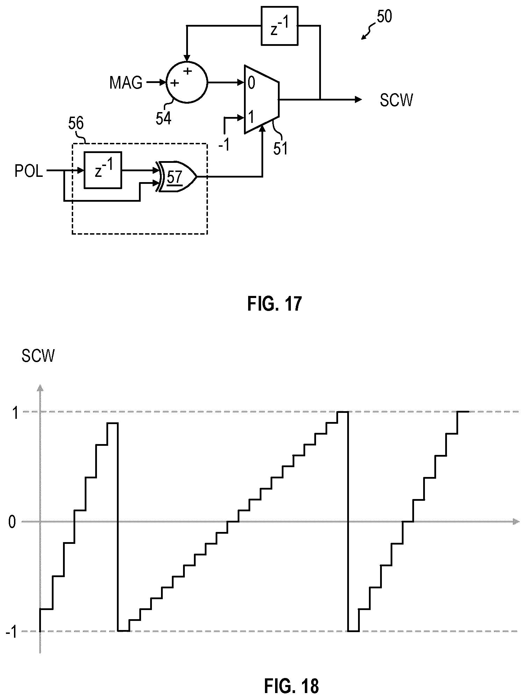

The integrator 50 for generating the carrier as a sawtooth carrier SCW can also be implemented digitally, as shown in FIG. 17. In greater detail, the integrator 50 includes an adder 54 that scales a delayed version of the sawtooth carrier by the magnitude signal MAG, and a multiplexer 51 that is controlled by the output of the edge detector 56 to output either a first logic value (e.g., a logic 1) or the output of the adder 54. The edge detector 56 includes an XOR gate 57 that compares the polarity signal POL to a delayed version of the polarity signal POL.

Here, the integration is performed in the positive direction. When the edge of the polariy signal POL occurs, the integration is reset to -1.

Observe in FIG, 18 a graph showing the sample sawtooth carrier resulting from positive integration, understood as a digital equivalent of the magnitude of the current output by the analog integrator 30 of FIG. 13. The lower the half-period of the sawtooth carrier, the higher the magnitude signal MAG, and the higher the half-period of the sawtooth carrier, the lower the magnitude signal MAG. If the magnitude signal MAG is insufficient to reach the peak of the sawtooth carrier, the edge detector 56 detects a change on the polarity signal POL and replaces the current value of the sawtooth carrier with the peak itself, so as to maintain the sawtooth carrier as having a constant peak-to-peak voltage, and on the next cycle, a reset is performed (either a transition to the lowest voltage). The magnitude signal itself MAG is, in this embodiment, always a positive integer.

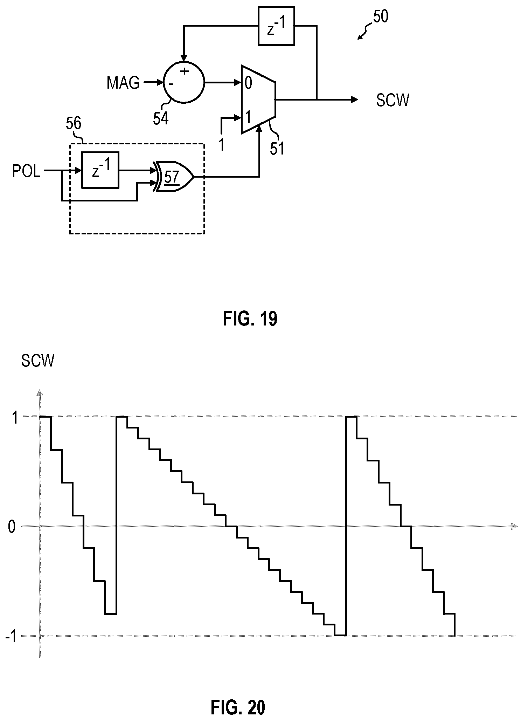

For negative integration, refer to FIG. 19, the operation is similar to that of the digital integrator 40 of FIG. 17, with the integration being reset to 1 at the edge of the polarity signal POL due to the second input of block 51 of FIG. 19 being selected, and with the magnitude signal MAG indicating the size of the piece of the sawtooth carrier generated for each clock cycle.

In the example of FIG. 19, the sawtooth carrier signal SCW is generated through negative this integration, with the reset of the sawtooth carrier to the positive peak being performed after a change in the polarity signal POL is detected by the edge detector 56..

Although this disclosure has been described with a limited number of embodiments, those skilled in the art, having the benefit of this disclosure, can envision other embodiments that do not deviate from the disclosed scope. Furthermore, skilled persons can envision embodiments that represent various combinations of the embodiments disclosed herein made in various ways.

**Claims**

1. A class-D amplifier (10'), comprising:

   modulated carrier generation circuitry (20) configured to generate a modulated carrier wave having a variable period and a constant peak-to-peak voltage amplitude,
   wherein the modulated carrier generation circuitry (20) comprises:

   modulation circuitry (22) configured to generate a modulating wave (MW);
   noise shaper circuitry (23) coupled to the modulation circuitry (22) to receive the modulating wave (MW) therefrom, the noise shaper circuitry (23) configured to apply noise shaper processing to the modulating wave (MW), producing a noise shaped output wave (NSH_OUT) as a result;
   carrier generation circuitry (25) configured to generate a period signal (CFP) having a programmable value, the period signal (CFP) representing a fundamental period of a carrier wave;
   an adder (24) coupled to the noise shaper circuitry (23) and to the carrier generation circuitry (25), the adder (24) configured to add the period signal (CFP) to the noise shaped output wave (NSH_OUT) to produce an updated counting top signal (COUNTING_TOP) representative of a new top count value;
   control signal generation circuitry (26) coupled to the adder to receive the updated counting top signal (COUNTING_TOP) therefrom, the control signal generation circuitry (26) configured to generate at least one control signal (1, 2, 3a, 3b, RST; POL, MAG) in response to receipt of the updated counting top signal (COUNTING_TOP);
   a counter circuit (27) coupled to the control signal generation circuitry (26), the counter circuit (27) configured to iterate a count (CNT) until the count (CNT) reaches the new top count value, the counter circuit (27) further configured to subsequently reset the count (CNT) and activate the noise shaper circuitry (23) to produce a new noise shaper output wave (NSH_OUT); and
integration circuitry (30) coupled to the control signal generation circuitry (26) and configured to generate the modulated carrier wave based on the at least one control signal (1, 2, 3a, 3b, RST; POL, MAG);
a pulse-width modulation, PWM signal generator (13) coupled to the integration circuitry (30) and configured to generate a PWM signal (PWM) by comparing an input voltage (V_Fil) to the modulated carrier wave venerated via the integration circuitry (30); and
a H-bridge circuit (14) coupled to the PWM signal generator (13) and configured to generate an output signal (V_Out) from the PWM signal (PWM),
preferably wherein the fundamental period of the carrier wave is dependent upon a clock used to clock the carrier generation circuitry (25).

2.  The class-D amplifier (10') of claim 1, wherein the control signal generation circuitry (26) comprises:

polarity generation circuitry (28) configured to invert a polarity signal (POL) in response to receipt of the updated counting top signal (COUNTING_TOP) to produce an updated polarity signal (POL); and
magnitude generation circuitry (29) configured to generate an updated magnitude signal (MAG) based upon the new top count value, in response to receipt of the updated counting top signal (COUNTING_TOP);

wherein:
the at least one control signal (1, 2, 3a, 3b, RST; POL, MAG) generated by the control signal generation circuitry (26) comprises the updated polarity signal (POL) and the updated magnitude signal (MAG); and
the integration circuitry (30) is configured to generate the modulated carrier wave based on the updated polarity signal (POL) and the updated magnitude signal (MAG), preferably wherein the integration circuitry comprises a constant peak-to-peak voltage, variable period sawtooth carrier generation circuit comprising a programmable current source comprising: a first current source (32(1)) configured to source a first current to a first node (Nn1); and a plurality of current sources (32(2), ..., 32(n)) configured to be selectively coupled to the first node (Nn1) by respective switches (S2, ..., Sn) so as to, in combination with the first current, source a current to the first node (Nn1) having a magnitude set based upon the updated magnitude signal (MAG); an integration capacitor (C) connected between the first node (Nn1) and ground; and a switch (SW) connected between the first node (Nn1) and ground and configured to close when the polarity signal (POL) is asserted; wherein the operation of the sourcing of the current to the first node (Nn1) having a magnitude set based upon the updated magnitude signal (MAG), together with discharging of the integration capacitor (C) to ground through closing of the switch (SW) upon assertion of the polarity signal (POL), serves to generate the constant peak-to-peak voltage, variable period sawtooth carrier generation circuit.

3.  The class-D amplifier (10') of claim 2, wherein the integration circuitry (30) comprises a programmable current source (31) configured:

when the polarity signal (POL) has a first logic value, to source a current having a magnitude set based upon the updated magnitude signal (MAG) to an integration input to produce an output integration voltage; and
when the polarity signal (POL) has a second logic value, to sink a current having a magnitude set based upon the updated magnitude signal (MAG) from the integration input to produce the output integration voltage; and
wherein the integration circuitry (30) further comprises an operational-amplifier configured into an integration feedback topology to produce the modulated carrier wave based on the integration voltage.

4.  The class-D amplifier (10') of claim 3, wherein the programmable current source (31) comprises:

a programmable current source circuit comprising a plurality of current sources (32(1), ..., 32(n)) and configured to activate a number of the plurality of current sources (32(1), ..., 32(n)) that is dependent upon the updated magnitude signal (MAG) to thereby source a current having a magnitude set based upon the updated magnitude signal (MAG) to the integration input; and
a programmable current sink circuit comprising a plurality of current sinks (33(1), ..., 33(n)) and configured to activate a number of the plurality of current sinks (33(1), ..., 33(n)) that is dependent upon the updated magnitude signal (MAG) to thereby sink a current having a magnitude set based upon the updated magnitude signal (MAG) from the integration input, preferably wherein the programmable current source circuit further comprises a first plurality of switches (S1, ..., Sn), each associated with a different one of the first plurality of current sources (32(1), ..., 32(n)), with activation of a given one of the plurality of current sources (32(1), ..., 32(n)) being performed by closing of a corresponding switch of the first plurality of switches (S1, ..., Sn); and wherein the programmable current sink circuit further comprises a second plurality of switches (SW1, ..., SWn), each associated with a different one of the plurality of current sinks (33(1), ..., 33(n)), with activation of a given one of the plurality of current sinks (33(1), ..., 33(n)) being performed by closing of a corresponding switch of the second plurality of switches (SW1, ..., SWn).

5.  The class-D amplifier (10') of claim 4, wherein the programmable current source circuit activates the number of the plurality of current sources (32(1), ..., 32(n)) based upon a logical combination of the updated magnitude signal (MAG) and the polarity signal (POL); and wherein the programmable current sink circuit activates the number of the plurality of current sinks (33(1), ..., 33(n)) based upon a logical combination of the updated magnitude signal (MAG) and the polarity signal (POL).

6.  The class-D amplifier (10') of claim 4, further comprising a switch circuit (Sd, Su) configured to connect the activated number of the plurality of current sources (32(1), ..., 32(n)) to the integration input when the polarity signal (POL) has the first logic value, but to connect the activated number of the plurality of current sinks (33(1), ..., 33(n)) to the integration input when the polarity signal (POL) has the second logic value.

7.  The class-D amplifier (10') of claim 3, wherein the programmable current source (31) comprises:
    a programmable current source circuit comprising:

    a first current source (32(1)) configured to source a first current to a first node (Nn1); and
    a first plurality of current sources (32(2), ..., 32(n)) configured to be selectively coupled to the first node (Nn1), with a number of the first plurality of current sources (32(2), ..., 32(n)) being coupled to the first node (Nn1) being dependent upon the updated magnitude signal (MAG) to thereby source a current having a magnitude set based upon the updated magnitude signal (MAG) to the first node (Nn1);
    a programmable current sink circuit comprising:

    a second current sink (33(1)) configured to source a second current from a second node (Nn2); and
    a second plurality of current sinks (33(2), ..., 33(n)) configured to be selectively coupled to the second node (Nn2), with a number of the second plurality of current sinks (33(2), ..., 33(n)) being coupled to the second node (Nn2) being dependent upon the updated magnitude signal (MAG) to thereby sink a current having a magnitude set based upon the updated magnitude signal (MAG) from the second node (Nn2); and
    a switch circuit (Sd, Su) configured to connect the first node (Nn1) to the integration input when the polarity signal (POL) has the first logic value, but to connect the second node (Nn2) to the integration input when the polarity signal (POL) has the second logic value.

8.  The class-D amplifier (10') of claim 3, wherein the programmable current source (31) comprises:
    a programmable current source circuit comprising:

    a first cascode current mirror (41) configured to have a reference current (IREF) sunk from its input and to mirror the reference current (IREF) to its output a plurality of first cascode transistor circuits (P5-P10) in a mirror arrangement with the first cascode current mirror (41); and
    a first plurality of switches (S2, ..., Sn), each associated with a different one of the plurality of first cascode transistor circuits (P7-P10) and configured to be selectively closed dependent upon the updated magnitude signal (MAG) to thereby source a current having a magnitude set based upon the updated magnitude signal (MAG) to a first node (Nn1);
    a programmable current sink circuit comprising:

    a second cascode current mirror (42) configured to receive the mirrored reference current (IREF) at its input;
    a plurality of second cascode transistor circuits (N3-N8) in a mirror arrangement with the second cascode current mirror (42); and
    a second plurality of switches (SW2, ..., SWn), each associated with a different one of the plurality of second cascode transistor circuits (N5-N8) and configured to be selectively closed dependent upon the updated magnitude signal (MAG) to thereby sink a current having a magnitude set based upon the updated magnitude signal (MAG) from a second node (Nn2); and
    a switch circuit (Sd, Su) configured to connect the first node (Nn1) to the integration input when the polarity signal (POL) has the first logic value, but to connect the second node (Nn2) to the integration input when the polarity signal (POL) has the second logic value,, preferably wherein the class-D amplifier (10') further comprises a voltage regulator arrangement (39, N0) configured to generate the reference current (IREF) and sink the reference current (IREF) from the input of the first cascode current mirror (41), preferably wherein the class-D amplifier (10') further comprises a diode coupled transistor (P0) selectively couplable to the first cascode current mirror (41) to adjust an average current in the first cascode current mirror (41).

9. The class-D amplifier (10') of claim 1, wherein the modulated carrier generation circuitry (20) is implemented digitally in an integrated circuit such that: the modulating wave (MW) is represented as a series of digital values; the noise shaping output (NSH_OUT) is represented as a series of digital values; the carrier wave is represented as a digital value representative of its fundamental period; the new top count value is represented as a digital value; and the count (CNT) is represented as a digital value, preferably wherein the magnitude generation circuitry (29) comprises a look-up circuit that looks-up a value to use as the updated magnitude signal (MAG) based upon the new top count value.

10. The class-D amplifier (10') of claim 1, wherein the noise shaping circuitry (23) comprises:

an input summer (123a) configured to subtract an error signal (ERR) from the modulating wave (MW) to produce a quantizer input signal (QUANTIZER_INPUT);
a quantizer (124) receiving the quantizer input signal (QUANTIZER_INPUT) and configured to divide the quantizer input signal (QUANTIZER_INPUT) by a scaling factor ($\gamma$) to produce the noise shaping output (NSH_OUT), and to multiply the noise shaping output (NSH_OUT) by the scaling factor ($\gamma$) to product a quantizer output signal (QUANTIZER_OUTPUT);
an error summer (123b) configured to subtract the quantizer input signal (QUANTIZER_INPUT) from the quantizer output signal (QUANTIZER_OUTPUT) to produce an intermediate output; and
a noise shaping filter (123c) configured to apply a noise shaping filter function (H(z)) to the intermediate output to produce the error signal (ERR), preferably wherein the quantizer input signal (QUANTIZER_INPUT) and quantizer output signal (QUANTIZER_OUTPUT) are digital; and wherein the quantizer (124) is implemented digitally.

11. The class-D amplifier (10') of claim 10, wherein the noise shaping filter (123c) comprises:

a finite impulse response filter, or
a binomial FIR filter configuration with coefficients arranged in an interleaved fashion, **characterized by** insertion of zero-value coefficients between binomial coefficients derived from Pascal's triangle.

12. The class-D amplifier (10') of claim 10, further comprising a dither generator configured to generate a dither signal (DITHER IN) having a range defined by the scaling factor ($\gamma$); and wherein the dither signal (DITHER_IN) is injected into the quantizer input signal (QUANTIZER_ INPUT) prior to quantization thereof by the quantizer (124).

13. The class-D amplifier (10') of claim 10, wherein the noise shaping circuitry (23) comprises:

a sigma delta modulator (122) configured to receive the modulating wave (MW) and a quantizer output signal (QUANTIZER_OUTPUT) as input and apply a two-input one-output filtering thereto to produce a quantizer input signal (QUANTIZER_INPUT); and
a quantizer (124) receiving the quantizer input signal (QUANTIZER_INPUT) and configured to divide the quantizer input signal (QUANTIZER_INPUT) by a scaling factor ($\gamma$) to produce the noise shaping output (NSH_OUT), and to multiply the noise shaping output (NSH_OUT) by the scaling factor ($\gamma$) to product the quantizer output signal (QUANTIZER_OUTPUT).

14. The class-D amplifier (10') of claim 2,
wherein the noise shaping circuitry (23) is configured to be activated to produce the new noise shaping output (NSH_OUT) only when the updated polarity signal (POL) is positive.

15. The class-D amplifier (10') of claim 2,
wherein the noise shaping circuitry (23) is configured to be activated to produce the new noise shaping output (NSH_OUT) only when the updated polarity signal (POL) is negative.

16. The class-D amplifier (10') of claim 1, wherein the integration circuitry (30) is implemented digitally, preferably to produce the modulated carrier wave as a sawtooth waveform or a triangular waveform.

17. The class-D amplifier (10') of claim 16, wherein the digitally implemented integration circuitry (40) comprises:

an edge detector (46) configured to detect edges of the polarity signal (POL);
a first multiplexer (41) configured to output either a positive logic value or a negative logic value, based upon the polarity signal (POL);
a second multiplexer (42) configured to output either the output of the first multiplexer (41) or a delayed version of the modulated carrier wave, based upon the detected edge of the polarity signal (POL);
a third multiplexer (45) configured to output either a negative version of the magnitude signal (MAG) or the magnitude signal (MAG), based upon the polarity signal (POL); and
a digital summer (44) configured to sum output of the second multiplexer (42) and output of the third multiplexer (45) to produce the modulated carrier wave;
wherein, during operation to perform positive integration, the polarity signal (POL) is at a logic one, so that the triangular carrier is generated by the digital summer (44) as a sum of a positive version of the magnitude signal (MAG) as output by the third multiplexer (45) and a delayed version of the modulated carrier wave, and
when the edge detector (46) detects a next edge of the polarity signal (POL), the triangular carrier is generated by the digital summer (44) as the sum of the negative version of the magnitude signal (MAG) and the positive logic value, thereby generating the modulated carrier wave as having a variable period but a constant peak-to-peak voltage;
wherein, during operation to perform negative integration, the polarity signal (POL) is at a logic zero, so that the triangular carrier is generated by the digital summer (44) as a sum of the negative version of the magnitude signal (MAG) as output by the third multiplexer (45) and the delayed version of the modulated carrier wave; and
when the edge detector (46) detects a next edge of the polarity signal (POL), the triangular carrier is generated by the digital summer (44) as the sum of the positive version of the magnitude signal (MAG) and the negative logic value, thereby generating the modulated carrier wave as a modulated triangular carrier wave having the variable period but the constant peak-to-peak voltage.

18. The class-D amplifier (10') of claim 16, wherein the digitally implemented integration circuitry (50) comprises, to perform positive integration:

an edge detector (56) configured to detect edges of the polarity signal (POL);
a digital summer (54) configured to sum the magnitude signal (MAG) and a delayed version of the modulated carrier wave to produce an intermediate output;
a multiplexer (51) configured to output the intermediate output unless the edge detector (56) detects an edge, at which point the multiplexer (51) outputs a negative logic value, thereby generating the modulated carrier wave as a modulated sawtooth carrier wave having the variable period but the constant peak-to-peak voltage.

19. The class-D amplifier (10') of claim 16, wherein the digitally implemented integration circuitry comprises, to perform negative integration:

an edge detector (56) configured to detect edges of the polarity signal (POL);
a digital summer (54) configured to subtract the magnitude signal (MAG) from a delayed version of the modulated carrier wave to produce an intermediate output;
a multiplexer (51) configured to output the intermediate output unless the edge detector (56) detects an edge, at which point the multiplexer (51) outputs a positive logic value, thereby generating the modulated carrier wave as a modulated sawtooth carrier wave having the variable period but the constant peak-to-peak voltage.

20. The class-D amplifier (10') of claim 4,
wherein the programmable current source circuit further comprises:

a first current source (32(1)) selectively coupled to the input to source current thereto; and
first plurality of switches (S1, ..., Sn), each associated with a different one of the first plurality of current sources (32(1), ..., 32(n)), with activation of a given one of the plurality of current sources (32(1), ..., 32(n)) being performed by closing of a corresponding switch of the first plurality of switches (S1, ..., Sn); and
wherein the programmable current sink circuit further comprises:

a second current sink (33(1)) selectively coupled to the input to sink current therefrom; and
a second plurality of switches (SW1, ..., SWn), each associated with a different one of the plurality of current sinks (33(1), ..., 33(n)), with activation of a given one of the plurality of current sinks (33(1), ..., 33(n)) being performed by closing of a corresponding switch of the second plurality of switches (SW1, ..., SWn).

FIG. 1

FIG. 2

**FIG. 3**

**FIG. 4**

**FIG. 5**

**FIG. 6**

23 ⌐

DITHER_IN → NSH_OUT

MW → + − 123a
QUANTIZER_INPUT
124

ERR

H(z)
123c   123b

QUANTIZER_OUTPUT

**FIG. 7A**

23 ⌐

DITHER_IN → NSH_OUT

MW → + − 123a
QUANTIZER_INPUT
124

ERR   123c(1)

H1(z)   FILT_IN   −   123b

SW

H2(z)
123c(2)

QUANTIZER_OUTPUT

**FIG. 7B**

122   23' ⌐

DITHER_IN → NSH_OUT

MW → L0
QUANTIZER_INPUT
124

L1

QUANTIZER_OUTPUT

**FIG. 8A**

122(1)   23' ⌐

DITHER_IN → NSH_OUT

MW → L0A
QUANTIZER_INPUT
124

L1A   SW

QUANTIZER_OUTPUT

L0B

L1B
122(2)

QUANTIZER_OUTPUT

**FIG. 8B**

FIG. 9

**FIG. 10**

**FIG. 11**

FIG. 12

EP 4 648 281 A1

FIG. 13

FIG. 14

26

FIG. 15

FIG. 16

**FIG. 17**

**FIG. 18**

**FIG. 19**

**FIG. 20**

**EUROPEAN SEARCH REPORT**

Application Number

EP 25 17 1361

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2002/075069 A1 (KARKI JAMES L [US] ET AL) 20 June 2002 (2002-06-20) * paragraph [0024]; figure 2 * | 1-20 | INV. H03F1/26 H03F3/187 H03F3/217 |
| A | US 2017/093279 A1 (HEZAR RAHMI [US] ET AL) 30 March 2017 (2017-03-30) * paragraphs [0002], [0016] - [0036]; figures 1-3,5 * | 1-20 | |
| A | CN 114 726 347 A (SUZHOU ZHISHENG SEMICONDUCTOR TECH CO LTD) 8 July 2022 (2022-07-08) * paragraphs [0002], [0078] - [0093]; figures 1,2a,2b,4-8 * | 1-20 | |
| A | CN 116 094 519 A (WUHAN POLYCORE MICROELECTRONICS CO LTD) 9 May 2023 (2023-05-09) * paragraphs [0003], [0006]; figures 1-5 * | 1-20 | |
| A | US 2004/232978 A1 (EASSON CRAIG ALEXANDER [US] ET AL) 25 November 2004 (2004-11-25) * paragraphs [0023], [0054]; figures 3,18 * | 1-20 | TECHNICAL FIELDS SEARCHED (IPC) H03F |

The present search report has been drawn up for all claims

| Place of search | Date of completion of the search | Examiner |
|---|---|---|
| The Hague | 23 August 2025 | Zakharian, Andre |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 17 1361

This annex lists the patent family members relating to the patent documents cited in the above-mentioned European search report.
The members are as contained in the European Patent Office EDP file on
The European Patent Office is in no way liable for these particulars which are merely given for the purpose of information.

23-08-2025

| Patent document cited in search report | Publication date | Patent family member(s) | Publication date |
|---|---|---|---|
| US 2002075069 A1 | 20-06-2002 | NONE | |
| US 2017093279 A1 | 30-03-2017 | NONE | |
| CN 114726347 A | 08-07-2022 | NONE | |
| CN 116094519 A | 09-05-2023 | NONE | |
| US 2004232978 A1 | 25-11-2004 | TW 200509523 A<br>US 2004232978 A1<br>WO 2004107565 A1 | 01-03-2005<br>25-11-2004<br>09-12-2004 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 17846520 B

**Non-patent literature cited in the description**

- Understanding Delta-Sigma Delta Data Converters. **PAVAN, SHANTHI** ; **SCHREIR, RICHARD** ; **TEMES, GABOR C.** IEEE Press Series on Microelectronic Systems. IEEE, 2017